# EUROPEAN PATENT APPLICATION

(11) **EP 1 855 382 A1**
(43) Date of publication of application: **14.11.2007**
(21) Application number: 06009699.7
(22) Date of filing: 10.05.2006
(51) Int. Cl.: H03L 7/085

(54) **Circuit and method for phase/frequency detection**

(71) Applicant: austriamicrosystems AG, 8141 Unterpremstätten (AT)
(72) Inventor: Ladvanszky, Janos, 8141 Unterpremstätten (AT); Gajdardziew, Andrzej, 8141 Unterpremstätten (AT)
(74) Representative: Epping - Hermann - Fischer

(57) **Abstract**

The present invention relates to a circuit for phase/frequency detection, comprising a first and a second D-latch (22, 27) and a logic circuit (38). The first D-latch (22) comprises a data input terminal (23), which is coupled to a reference terminal (20), and a clock input terminal (24), which is coupled to an oscillator terminal (21). The second D-latch (27) comprises a data input terminal (28) coupled to the oscillator terminal (21) and a clock input terminal (29) coupled to the reference terminal (20). The logic circuit (38) comprises a first and a second input terminal which is connected to the first D-Latch (22) and to the second D-Latch (27) respectively and a first and a second phase detector terminal (34, 35) for providing a first and a second phase detector signal (Vup, Vdo) respectively.

## Description

The present invention relates to a circuit for phase/frequency detection, a phase locked loop circuit comprising the circuit for phase/frequency detection and a method for phase/frequency detection.

Circuits for phase/frequency detection are mainly used in phase locked loop circuits and are designed for the comparison of two signals. A circuit for phase/frequency detection provides a phase detector signal depending on the phase difference of two signals which are received by the circuit for phase/frequency detection.

In the document by C. A. Sharpe, "A 3-state phase detector can improve your next PLL design", EDN Magazine, September 20, 1976, Figure 9., a phase/frequency detection with D-latches is presented.

It is an object of the present invention to provide a circuit and a method for phase/frequency detection achieving a stable operation and a cost-effective arrangement.

This object is solved by a circuit for phase/frequency detection comprising the features of claim 1 and a method for phase/frequency detection according to claim 13. Preferred embodiments are presented in the dependent claims.

A circuit for phase/frequency detection comprises a first and a second D-latch and a logic circuit. The first D-latch comprises a data input terminal and a clock input terminal and, in an analogous way, the second D-latch also comprises a data input terminal and a clock input terminal. A reference terminal of the circuit is connected to the data input terminal of the first D-latch and to the clock input terminal of the second D-latch. An oscillator terminal of the circuit is connected to the clock input terminal of the first D-latch and to the data input terminal of the second D-latch. The logic circuit comprises a first and a second input terminal and, at the output-side of the logic circuit, a first and a second phase detector terminal. The first input terminal of the logic circuit is coupled to the first D-latch and the second input terminal of the logic circuit is coupled to the second D-latch.

A reference signal is received by the reference terminal and an oscillator signal is received by the oscillator terminal. Therefore, the reference signal is fed to the data input terminal of the first D-latch and the clock input terminal of the second D-latch, while the oscillator signal is fed to the clock input terminal of the first D-latch and to the data input terminal of the second D-latch. A result of the first D-latch and a result of the second D-latch are provided to the logic circuit. The logic circuit generates a first and a second phase detector signal and provides them at the first and the second phase detector terminal, respectively.

It is an advantage of the circuit for phase/frequency detection that a maximum of two feedback loops are provided which can be arranged in the first and the second D-latch. D-latches are common and well characterized and can be designed in such a way that they show a very high stability. Therefore, the circuit for phase/frequency detection can be realized with a high stability.

Stability is further increased by eliminating any feedback from the logic circuit.

In an embodiment, an inverted output terminal of the first D-latch is coupled to the first input terminal of the logic circuit and an inverted output terminal of the second D-latch is coupled to the second input terminal of the logic circuit.

In an embodiment, the oscillator terminal is coupled to a third input terminal of the logic circuit and the reference terminal is coupled to a fourth input terminal of the logic circuit. According to this embodiment, the logic circuit comprises four input terminals.

In an embodiment, the logic circuit is realized in such a way that is provides the first phase detector signal or the second phase detector signal with a high-state only in the case of different states of the reference signal and the oscillator signal. In the case that the reference signal and the oscillator signal both show a high-state signal or both show a low-state signal, the first and the second phase detector signal show a low-state signal. Therefore, unequal oscillator and reference signal levels are a prerequisite for a high-state of the first or the second phase detector signal.

In a further development, the logic circuit is designed to provide the first phase detector signal with a high-state only in case of a high-state at the inverted output terminal of the first D-latch and unequal reference and oscillator signals. The logic circuit can be realized in such a way that the second phase detector signal only shows a high-state in case of a high-state at the inverted output terminal of the second D-latch and unequal reference and oscillator signals.

In an embodiment, the logic circuit comprises a first logic sub-circuit with two input terminals which are coupled to the reference and the oscillator terminals. The logic circuit further comprises a second logic sub-circuit which is coupled on the input-side to an output terminal of the first logic sub-circuit and to the inverted output terminal of the first D-latch. In an analogous way, a third logic sub-circuit of the logic circuit comprises two input terminals which are coupled to the output terminal of the first logic sub-circuit and to the inverted output terminal of the second D-latch. An output terminal of the second logic sub-circuit and an output terminal of the third logic sub-circuit are connected with the first and the second phase detector terminals respectively.

In an embodiment, the first logic sub-circuit comprises an exclusive OR-gate and the second and the third logic subcircuits are designed as AND-gates. In an alternative embodiment, the logic circuit comprises a circuit which is logically equivalent to the arrangement of the exclusive OR-gate and the first and the second AND-gates. NOR-gates can be used for the realization of the equivalent logic circuit. In an alternative embodiment, NAND-gates are used for the realization of the equivalent logic circuit.

In an embodiment, the circuit for phase/frequency detection comprises a subtracting circuit which is coupled on the input side to the first and the second phase detector terminal and provides a phase detector signal.

According to an aspect of the invention, a phase locked loop circuit is provided comprising the circuit for phase/frequency detection. The phase locked loop, abbreviated PLL, further comprises a loop filter, an oscillator and a further reference terminal. The reference oscillator can be coupled to the phase locked loop circuit via the further reference terminal.

In an embodiment the PLL comprises a charge pump, which is connected to the first and the second phase detector terminals and provides a charge pump signal in dependency of the first and the second phase detector signal.

The phase locked loop circuit, comprising the circuit for phase/frequency detection, the loop filter and the oscillator, can be realized on a semiconductor body. The reference oscillator can be coupled to the semiconductor body via the further reference input terminal.

The oscillator can be realized as voltage controlled oscillator.

The phase locked loop circuit can be arranged in a device for mobile communication.

According to an aspect of the invention, a method for phase/frequency detection comprises the steps of: a reference signal is received by a data input terminal of a first D-latch and by a clock input terminal of a second D-latch. An oscillator signal is received by a clock input terminal of the first D-latch and by a data input terminal of the second D-latch. A high-state is set in a first phase detector signal in case of unequal states of the reference signal and the oscillator signal and a high-state at the inverted output terminal of the first D-latch. A second phase detector signal assumes a high-state in case of unequal states of the reference signal and the oscillator signal and of a high-state at the inverted output terminal of the second D-latch.

In an embodiment, a phase detector signal is generated by adding the first phase detector signal and a signal which is the inverted signal of the second phase detector signal.

The following description of figures of exemplary embodiments may further illustrate and explain the invention. Devices with the same structure and with the same effect, respectively, appear with equivalent reference numerals. A description of a part of a circuit or a device which has the same function in different figures may not be repeated in each of the following figures.
- FIGS. 1A and 1B: show a schematic of exemplary embodiments of a phase locked loop in which the circuit for phase/frequency detection of the principle presented can be applied,
- FIG. 2: shows an exemplary embodiment of a circuit for phase/frequency detection of the principle presented,
- FIG. 3: shows an exemplary embodiment of a D-latch,
- FIGS. 4A and 4B: show a transfer characteristic and a time schedule of signals of the circuit for phase/frequency detection shown in FIG. 2,
- FIGS. 5A to 5I: show output signals of a circuit for phase/frequency detection shown in FIG. 2 in dependency of different input signals.

FIG. 1A shows an exemplary embodiment of a schematic of a phase locked loop circuit. The phase locked loop comprises a circuit for phase/frequency detection 3, abbreviated phase detector, a loop filter 4, an oscillator 2 and a reference oscillator 1. The phase detector 3 comprises two input terminals, which are a reference terminal 20 and an oscillator terminal 21. The phase detector 3 further comprises a phase detector terminal 37 at the output-side of the phase detector 3. The phase detector terminal 37 is coupled to the loop filter 4, which is coupled to the oscillator 2. The oscillator 2 comprises two terminals at its output-side, the first one of the output terminals of the oscillator 2 is coupled to the oscillator terminal 21 of the phase detector 3. The reference terminal 20 of the phase detector 3 is coupled with an output-side terminal of the reference oscillator 1.

The reference oscillator 1 provides a reference signal Vref to the reference terminal 20 of the phase detector 3. In an analogue way, the oscillator 2 provides an oscillator signal Vvco to the oscillator terminal 21 of the phase detector 3. The phase detector 3 generates a phase detector signal Vpd and provides the phase detector signal Vpd at its phase detector terminal 37. The loop filter 4 receives the phase detector signal Vpd and generates a filter signal Vf which is provided to the oscillator 2. The oscillator 2 not only generates the oscillator signal Vvco but also an output signal Voutput which can be used in a arrangement in which the phase locked loop circuit is inserted in.

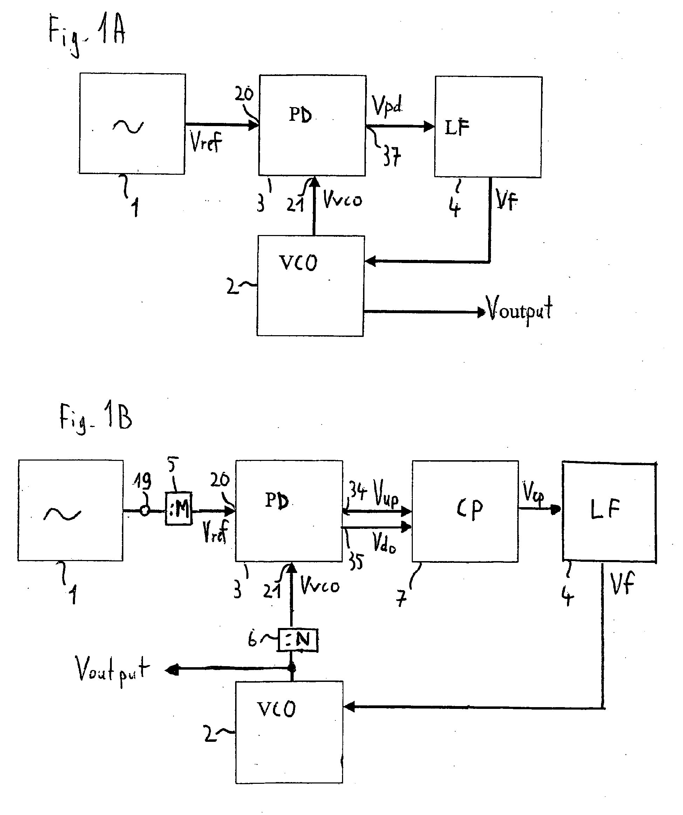

FIG. 1B shows a further development of the phase locked loop shown in FIG. 1A. In addition to the phase locked loop in FIG. 1A, the phase locked loop according to FIG. 1B comprises a first and a second frequency divider 5, 6 and a further reference terminal 19. The reference oscillator 1 is coupled via the further reference terminal 19 and via the first frequency divider 5 to the reference terminal 20 of the phase detector 3. In an analogous way, the output-side terminal of the oscillator 2 is coupled via the second frequency divider 6 to the oscillator terminal 21 of the phase detector 3.

According to FIG. 1B, the phase locked loop comprises a charge pump 7 which couples the phase detector 3 and the loop filter 4. According to this embodiment, the phase detector 3 has two output-side terminals which are a first phase detector terminal 34 and a second phase detector terminal 35. Both terminals are connected to the charge pump 7. The charge pump 7 comprises one output-side terminal which is connected to the input-side terminal of the loop filter 4. The oscillator 2 can be realized as a voltage controlled oscillator.

The first frequency divider 5 is used to provide a reference signal Vref with a frequency which is by a factor M smaller than the frequency of the reference oscillator 1. The second frequency divider 6 is provided to provide an oscillator signal Vvco with a frequency which is by the factor N smaller than the frequency at the output-side terminal of the oscillator 2. This output-side terminal of the oscillator 2 provides an output signal Voutput. The charge pump then receives a first and a second phase detector signal Vup, Vdo and generates a charge pump signal Vcp which is provided to the loop filter 4.

It is an advantage of the first and second frequency divider 5, 6 that the frequency of the output signal Voutput can be larger than the frequency of the reference oscillator 1.

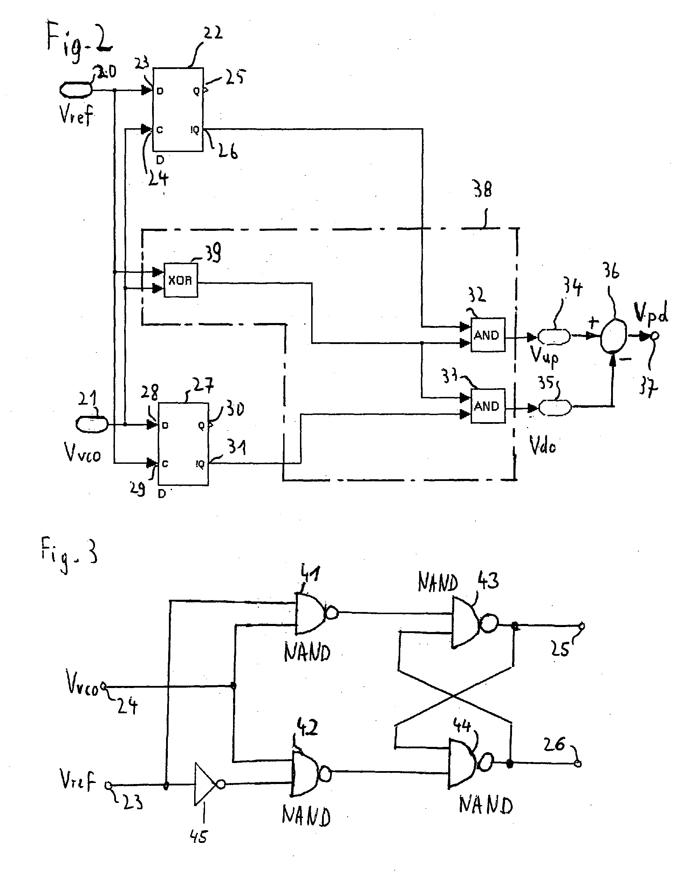

FIG. 2 shows an exemplary embodiment of the phase detector 3 which can be arranged in the phase locked loop shown in FIG. 1A and in FIG. 1B. The phase detector 3 comprises a first and a second D-latch 22, 27, a logic circuit 38 and two input-side terminals, which are the reference terminal 20 and the oscillator terminal 21. The reference terminal 20 is connected to the data input terminal 23 of the first D-latch 22 and to the clock input terminal 29 of the second D-latch 27. The oscillator terminal 21 is connected to the clock input terminal 24 of the first D-latch 22 and to the data input terminal 28 of the second D-latch 27. The logic circuit 38 has four input terminals. The logic circuit 38 is connected to an inverted output terminal 26 of the first D-latch 22, an inverted output terminal 31 of the second D-latch 27, to the reference terminal 20 and to the oscillator terminal 21. On the output side, the logic circuit 38 comprises the first and the second phase detector terminals 34, 35. These two terminals are connected to a subtracting circuit 36 which is connected to the phase detector terminal 37.

The logic circuit 38 comprises an exclusive OR gate 39 and a first and a second AND gate 32, 33. The exclusive OR gate 39 is connected at its input-side to the reference terminal 20 and the oscillator terminal 21. The first AND gate 32 is connected to an inverted output terminal 26 of the first D-latch 22 and an output terminal of the exclusive OR gate 39. In an analogues manner, the second AND gate 33 is connected at its input-side to the output terminal of the exclusive OR gate 39 and to an inverted output terminal 31 of the second D-latch 27. The output terminals of the first and the second AND gates 32, 33 are connected to the first and second phase detector terminals 34, 35.

The reference signal Vref is provided via the reference terminal 20 to the data input terminal 23 of the first D-latch 22 and to the clock input terminal 29 of the second D-latch 27. In a corresponding manner, the oscillator signal Vvco is provided via the oscillator terminal 22 to the clock input terminal 24 of the first D-latch 22 and to the data input terminal 28 of the second D-latch 27.

The exclusive OR gate 39 receives the reference signal Vref and the oscillator signal Vvco and provides an output signal with a high-state in the case that the reference signal Vref and the oscillator Vvco have unequal states. The output signal of the exclusive OR gate 39 is in a low-state, if the reference signal Vref and the oscillator signal Vvco are in the same state. The effect of the first AND gate 32 is that it provides a first phase detector signal Vup if the inverted output terminal 26 of the first D-latch 22 provides a signal with a high-state and the exclusive OR gate 39 also provides a signal with a high-state. In all other cases the first phase detector signal Vup is in a low-state. In a corresponding manner, the second AND gate 33 provides a second phase detector signal Vdo with a high-state, if a signal at the inverted output terminal 31 of the second D-latch 27 is in a high-state and the output signal of the exclusive OR gate 39 is also in a high-state. In all other cases the second phase detector signal Vdo is in a low-state.

The subtracting circuit 36 provides a phase detector signal Vpd with a high-state, a low-state and an inverted high-state. The phase detector signal Vpd is in a high-state in case that first phase detector signal Vup is in a high-state and the second phase detector signal Vdo is in a low-state. The phase detector signal Vpd is in an inverted high-state in case that the second phase detector signal Vdo is in a high-state and the first phase detector signal Vup is in a low-state. In all other cases the phase detector signal Vpd is in a low-state.

It is an advantage of the embodiment that there are no feedback loops in the logic circuit 38 and, therefore, the only feedback loops in the phase detector 3 are situated in the first and the second D-latch 22, 27. This yields a high stability of the phase detector 3. The number of logic gates in this schematic is very low, so that the phase detector 3 can be realized in a cost-effective manner. It is a further advantage of the embodiment that the phase detector 3 is symmetrical with respect to the reference terminal and the oscillator terminal 21.

In an alternative embodiment the exclusive OR gate 39 and the two AND gates 32, 33 are realized using several NAND gates. In a further alternative embodiment the exclusive OR gate 39 and the two AND gates 32, 33 are realized using NOR gates. In an alternative embodiment an output terminal 25 of the first D-latch 22 and an output terminal 30 of the second D-latch 27 are used instead of the inverted output terminals 26, 31. The number of the required NOR gates or NAND gates may be minimized by removing redundant logic gates without changing the functionality of the phase detector 3.

Figure 3 shows an exemplary embodiment of a D-latch, which can be inserted as the first D-latch 22 or the second D-latch 27 in the phase detector shown in Figure 2. The D-latch comprises four NAND gates 41 - 44 and an inverter 45.

In an alternative embodiment the D-latch does not comprise the inverter 45 and, instead of the inverter 45, an output terminal of the first NAND gate 41 is connected to one of the input terminals of the second NAND gate 42 as shown in Figure 3 with the interrupted line.

In an alternative embodiment the D-latch comprises NOR gates instead of the NAND gates.

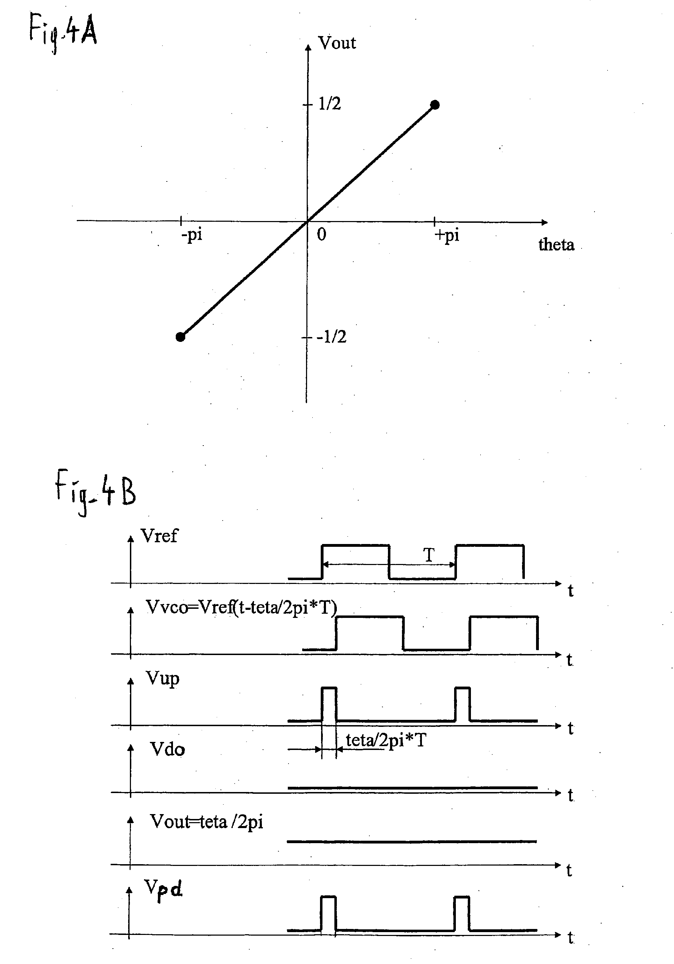

Figure 4A shows an exemplary transfer characteristic of the phase detector 3. The first coordinate shows an angle theta which is the angle of the phase difference of the reference signal Vref and the oscillator signal Vvco and is in range of - pi to + pi with pi equals approximately 3,1416. The second coordinate shows an average phase detector signal Vout which is the phase detector signal Vpd after calculating an average about one period T of the reference signal Vref. An average phase detector signal Vout ranges from - 0.5 to + 0.5. The angle theta and the average phase detector signal Vout are further explained in Figure 4B.

Figure 4B shows the time dependencies of six signals, namely the reference signal Vref, the oscillator signal Vvco, the first phase detector signal Vup, the second phase detector signal Vdo, the average phase detector signal Vout and the phase detector signal Vpd. The rising edges of the oscillator signal Vvco are behind the rising edges of the reference signal by the angle theta. Therefore, the second phase detector signal Vdo is in a low-state and the first phase detector signal Vup is in a high-state during the time, in which the reference signal Vref is already in a high-state and the oscillator signal Vvco is still in a low-state. The phase detector signal Vpd is equal to the first phase detector signal Vup in this example.

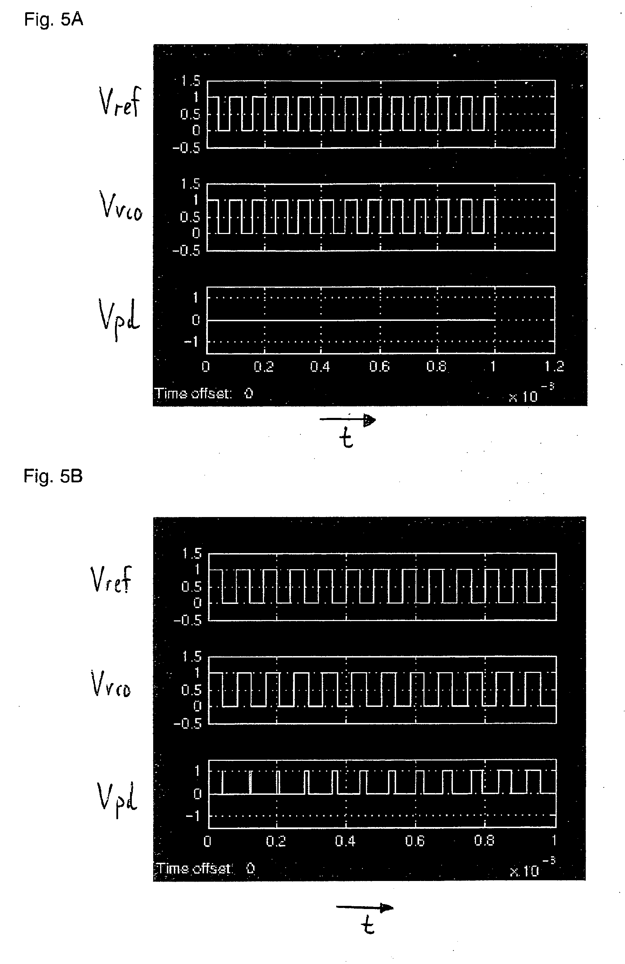

Figure 5A to 5I show exemplary time dependencies of the reference signal Vref, the oscillator signal Vvco and the phase detector signal Vpd. The reference signal Vref is shown in the upper curve, the oscillator signal Vvco is demonstrated in the second curve and the phase detector signal Vpd is exhibited in the third curve. The phase detector signal Vpd is calculated according to the equation Vpd = Vup - Vdo. The horizontal axes represent the time t in seconds. The drawings show simulation results. The used frequencies and delay times are examples. The phase detector is also able to operate at higher frequencies.

Figure 5A shows a reference signal Vref and a oscillator signal Vvco which are equal. Therefore, the phase detector signal Vpd is in a low-state.

Figure 5B shows a oscillator signal Vvco with a smaller frequency in comparison with the reference signal Vref. In this example the oscillator signal Vvco has an oscillator frequency of 12 kHz and the reference signal Vref has a reference frequency of 12.5 kHz. The phase detector signal Vpd shows pulses with a high-state which become longer with increasing time t.

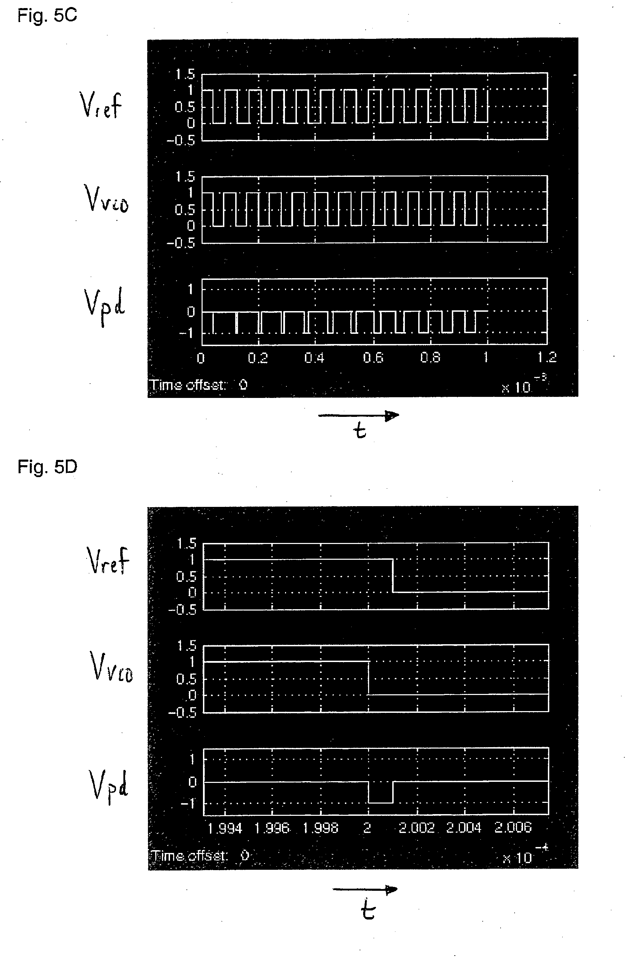

Figure 5C shows an opposite situation in comparison with Figure 5B. A reference frequency is smaller in comparison with the oscillator frequency Vvco. The reference frequency is 12 KHz, while the oscillator frequency is 12.5 KHz. The phase detector signal Vpd shows pulses with an inverted high-state which become longer with increasing time t.

Figure 5D shows a reference signal Vref which has a small positive delay in comparison with the oscillator signal Vvco. Both frequencies are 12.5 kHz. The delay of the reference signal Vref is 100 ns. Therefore, the phase detector signal Vpd is in a low-state for most of the time and in an inverted high-state for a relatively short time.

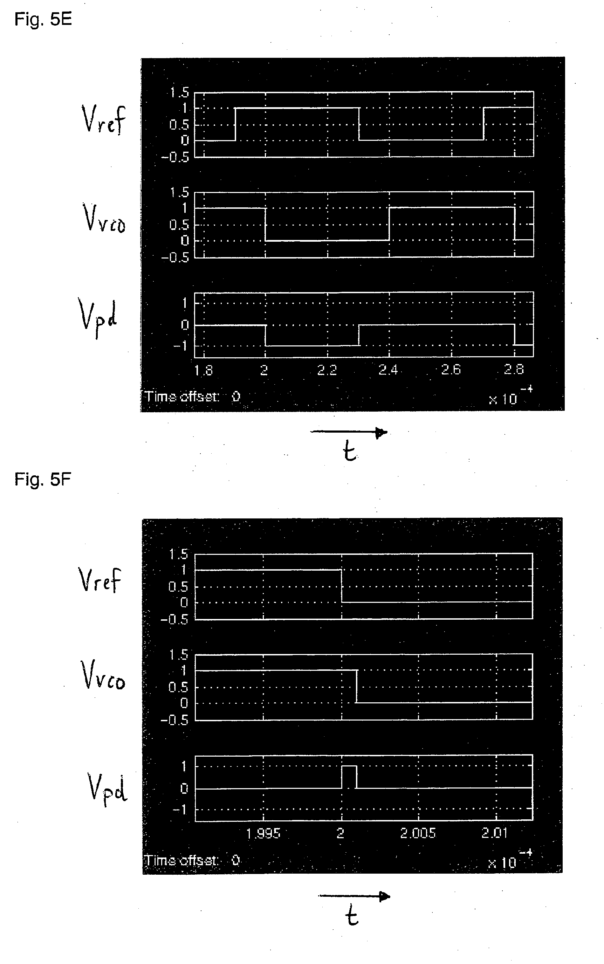

Figure 5E shows a reference signal Vref which has a large positive delay in comparison with the oscillator signal Vvco. The delay of the reference signal Vref is 30 µs. Therefore, the phase detector signal Vpd shows an inverted high-state for a longer time in comparison with the time for the inverted high-state in Figure 5D.

Figure 5F shows a reference signal Vref which has a small negative delay in comparison with the oscillator signal Vvco. The delay of the reference signal is minus 100 ns. Therefore, the phase detector signal Vpd shows a high-state with a small duration.

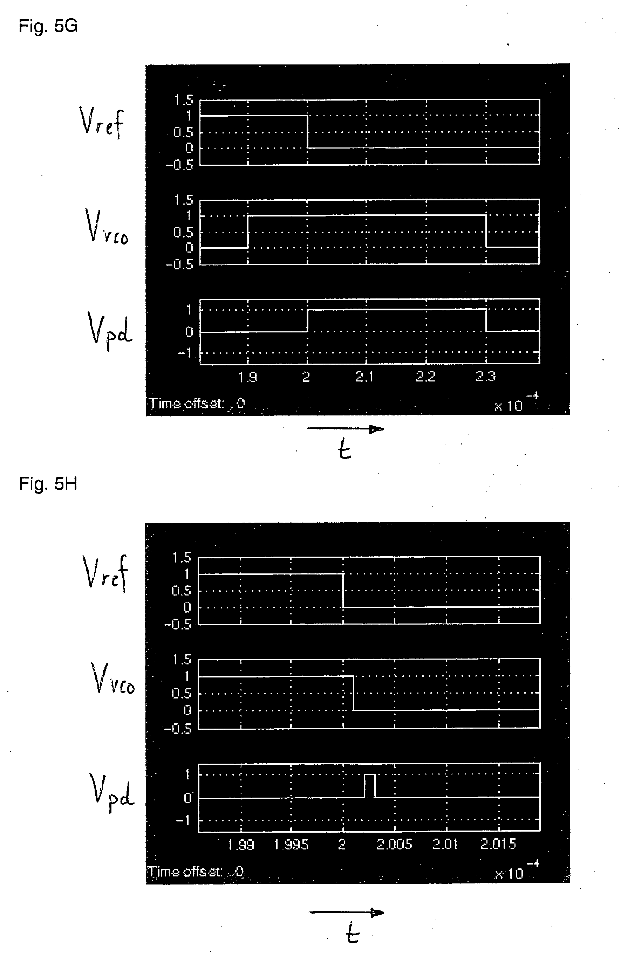

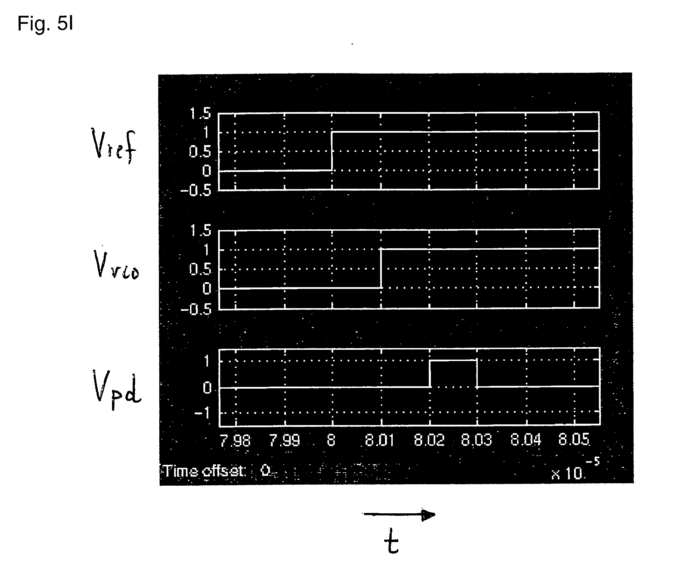

Figure 5G shows a reference signal Vref which has a large negative delay in comparison with the oscillator signal Vosc. The delay of the reference signal Vref is minus 30 µs. Therefore, the phase detector signal Vpd shows a high-state for a longer time in comparison with Figure 5F.

Figure 5H shows a reference signal Vref with a small negative delay of minus 100 ns in comparison with the oscillator signal Vosc. The delays of the gates 32, 33, 39 and the D-latches 22, 27 are assumed to be equal and to be 100 ns. Therefore, the phase detector signal Vpd comprises a high-state for a small period of time. The high-state pulse rises after the falling edge of the oscillator signal Vvco.

Figure 5I shows a reference signal Vref with a small delay of minus 100 ns in comparison with the oscillator signal Vvco. The delays of the gates 32, 33, 39 are assumed to be 100 ns and the delays of the D-latches 22, 27 are assumed to be 300 ns. The phase detector signal Vpd is in a high-state for a small period of time which is situated after the rising edge of the oscillator signal Vosc.

The simulation results in figures 5A to 5I show the correct functionality of the phase detector 3 in a simulated environment with different reference signals Vref and oscillator signals Vosc and confirm the advantages achieved by the principle presented.

### Reference numerals

- 1: reference oscillator
- 2: oscillator
- 3: phase detector
- 4: loop filter
- 5: first frequency divider
- 6: second frequency divider
- 7: charge pump
- 19: further reference terminal
- 20: reference terminal
- 21: oscillator terminal
- 22: first D-latch
- 23: data input terminal
- 24: clock input terminal
- 25: output terminal
- 26: inverted output terminal
- 27: second D-latch
- 28: data input terminal
- 29: clock input terminal
- 30: output terminal
- 31: inverted output terminal
- 32: first AND gate
- 33: second AND gate
- 34: first phase detector terminal
- 35: second phase detector terminal
- 36: subtracting circuit
- 37: phase detector terminal
- 38: logic circuit
- 39: exclusive OR gate
- 41: first NAND gate
- 42: second NAND gate
- 43: third NAND gate
- 44: fourth NAND gate
- 45: inverter
- t: time
- T: period
- theta: angle
- Vcp: charge pump signal
- Vdo: second phase detector signal
- Vf: filter signal
- Vout: average phase detector signal
- Voutput: output signal
- Vpd: phase detector signal
- Vup: first phase detector signal
- Vref: reference signal
- Vvco: oscillator signal

## Claims

1. Circuit for phase/frequency detection, comprising
- a first D-latch (22) which comprises
- a data input terminal (23), which is coupled to a reference terminal (20), and
- a clock input terminal (24), which is coupled to an oscillator terminal (21),
- a second D-latch (27) which comprises
- a data input terminal (28), which is coupled to the oscillator terminal (21), and
- a clock input terminal (29), which is coupled to the reference terminal (20), and
- a logic circuit (38), comprising
- a first input terminal which is connected to the first D-Latch (22),
- a second input terminal which is connected to the second D-Latch (27),
- a first phase detector terminal (34) for providing a first phase detector signal (Vup) and
- a second phase detector terminal (35) for providing a second phase detector signal (Vdo).

2. Circuit according to claim 1,
wherein
- the data input terminal (23) of the first D-latch (22) and the clock input terminal (29) of the second D-latch (27) are directly connected to the reference terminal (20) and
- the clock input terminal (24) of the first D-latch (22) and the data input terminal (28) of the second D-latch (27) are directly connected to the oscillator terminal (21).

3. Circuit according to claim 1 or 2,
wherein
- a third input terminal of the logic circuit (38) is connected to the oscillator terminal (21) and
- a fourth input terminal of the logic circuit (38) is connected to the reference terminal (20).

4. Circuit according to claim 3,
wherein the logic circuit (38) is designed for providing a high-state in the first phase detector signal (Vup) or in the second phase detector signal (Vdo) only in case of unequal states of a reference signal (Vref) which is received at the reference terminal (20) and an oscillator signal (Vosc) which is received at the oscillator terminal (21).

5. Circuit according to one of claims 1 to 4,
wherein
- the first input terminal of the logic circuit (38) is connected to an inverted output terminal (26) of the first D-Latch (22) and
- the second input terminal of the logic circuit (38) is connected an inverted output terminal (31) of the second D-Latch (27).

6. Circuit according to claim 5,
wherein the logic circuit (38) is designed for providing
- a high-state in the first phase detector signal (Vup) only in case of a high-state at the inverted output terminal (26) of the first D-Latch (22) and
- a high-state in the second phase detector signal (Vdo) only in case of a high-state at the inverted output terminal (31) of the second D-Latch (27).

7. Circuit according to claim 5 or 6,
wherein the logic circuit (38) comprises
- an exclusive OR gate (39) with two input terminals connected to the reference terminal (20) and the oscillator terminal (21),
- a first AND gate (32) with two input terminals connected to an output terminal of the exclusive OR gate (39) and to the inverted output terminal (26) of the first D-latch (22) and with an output terminal connected to the first phase detector terminal (34), and
- a second AND gate (33) with two input terminals connected to the output terminal of the exclusive OR gate (39) and to the inverted output terminal (31) of the second D-latch (27) and with an output terminal connected to the second phase detector terminal (35).

8. Circuit according to claim 7,
wherein the logic circuit (38) comprises a digital processing circuit with a functionality which is logically equal to the functionality of the logic circuit (38).

9. Circuit according to one of claims 1 to 8,
wherein the first D-latch (22) comprises
- a first NAND gate (41) with two input terminals, which are connected to the data input terminal (23) and the clock input terminal (24),
- a second NAND gate (42) with a first input terminal, which is connected to the clock input terminal (24),
- a third NAND gate (43) with a first input terminal, which is connected to an output terminal of the first NAND gate (41), and an output terminal, which is connected to the output terminal (25) of the first D-latch (22), and
- a fourth NAND gate (44) with two input terminals, which are connected to an output terminal of the second NAND gate (42) and to the output terminal of the third NAND gate (43), and an output terminal, which is connected to a second input terminal of the third NAND gate (43) and the inverted output terminal (26) of the first D-latch (22).

10. Circuit according to claim 9,
wherein a second input terminal of the second NAND gate (42) is coupled
- via an inverter (45) to the data input terminal (23) of the second NAND gate (42) or
- to the output terminal of the first NAND gate (41).

11. Circuit according to one of claims 1 to 10,
wherein the first phase detector terminal (34) and the second phase detector terminal (35) are coupled to a phase detector terminal (37) via a subtracting circuit (36) for providing a phase detector signal (Vpd).

12. Phase locked loop circuit, comprising a circuit for phase/frequency detection according to one of claims 1 to 11 and
- a loop filter (4) with an input terminal, which is coupled to the circuit (3) for phase/frequency detection,
- an oscillator (2) with an input terminal, which is coupled to the loop filter (4), and an output terminal, which is coupled to the oscillator input terminal (21) of the circuit (3) for phase/frequency detection forming an feedback path, and
- a further reference input terminal (19), which is coupled to a reference oscillator (1) and the reference input terminal (20) of the circuit (3) for phase/frequency detection.

13. Method for phase/frequency detection, comprising the steps of:
- providing a reference signal (Vref) to a data input terminal (23) of a first D-latch (22) and providing an oscillator signal (Vvco) to a clock input terminal (24) of the first D-latch (22),
- providing the reference signal (Vref) to a clock input terminal (29) of a second D-latch (27) and providing the oscillator signal (Vvco) to a data input terminal (28) of the second D-latch (27),
- comparing the reference signal (Vref) and the oscillator signal (Vosc) and providing a result of the comparison,
- providing the first phase detector signal (Vup) with a high-state depending on the result of the comparison and a signal at the inverted output terminal (26) of the first D-Latch (22) and
- providing the second phase detector signal (Vdo) with a high-state depending on the result of the comparison and a signal at the inverted output terminal (31) of the second D-Latch (27).

14. Method according claim 13,
wherein a phase detector signal (Vpd) is provided by a charge pump (7) depending on the first and the second phase detector signal (Vup, Vdo).
